# EUROPÄISCHE PATENTSCHRIFT

(11) **EP 0 823 096 B1**
(45) Veröffentlichungstag und Bekanntmachung des Hinweises auf die Patenterteilung: **27.08.2003**
(21) Anmeldenummer: 97917235.0
(22) Anmeldetag: 21.02.1997
(51) Int. Cl.: G06K 1/12, G06K 19/08

(54) **VERFAHREN ZUR HERSTELLUNG EINER CHIPKARTE**
METHOD OF PRODUCING A SMART CARD
PROCEDE DE PRODUCTION D'UNE CARTE A PUCE

(30) Priorität: 23.02.1996 DE 19606782
(43) Veröffentlichungstag der Anmeldung: 11.02.1998
(73) Patentinhaber: Orga Kartensysteme GmbH, 33104 Paderborn (DE)
(72) Erfinder: FANNASH, Lothar, D-48167 Münster (DE); TRÜGGELMANN, Uwe, D-33098 Paderborn (DE)
(86) Internationale Anmeldenummer: DE9700318
(87) Internationale Veröffentlichungsnummer: WO97031323

(56) Entgegenhaltungen:
- EP-A- 0 463 930
- EP-A- 0 587 262
- US-A- 4 564 739

## Beschreibung

Die Erfindung bezieht sich auf ein Verfahren zur Herstellung von kontaktbehafteten Chipkarten. Derartige Chipkarten enthalten ein Chipmodul, d.h. ein Trägerelement für den Chip/IC-Baustein, mit elektrisch leitfähigen Kontakten. Diese Kontakte sind mit entsprechenden Anschlußpunkten des Chips leitend verbunden, so daß hierüber die Kommunikation der Chipkarte mit entsprechenden Geräten (Chipkartenterminals) ermöglicht wird. Das Chipmodul wird in einer zur Kartenvorderseite hin offenen Aussparung des Kartenkörpers fixiert.
Derartige Chipkarten haben bereits eine große Verbreitung gefunden in Form von Telefonkarten, Krankenversichertenkarten, GSM-Karten, Bank- und Kreditkarten etc.

Das Layout dieser Karten (Kartenvorderseite und Rückseite) ist in aufwendiger Weise, meistens mehrfarbig gestaltet; wohingegen momentan nur Chipmodule mit einer gold- oder silberfarbenen Oberfläche der Kontakte verfügbar sind. Dabei sind diese Kontakte meisten so aufgebaut, daß auf eine Kupferschicht eine Metallisierung aus Nickel als Diffusionsbarriere und darauf Gold, Silber oder Palladium aufgebracht wird, wobei auch die Palladium-Metallisierung silberfarben erscheint. Hinsichtlcih des optischen Erscheinungsbildes der Chipmoduloberfläche sind bisher kaum Gestaltungsmöglichkeiten gegeben.

In der EP 0 589 732 ist das Markiern (Aufbringen von sichtbaren Informationen) auf die metallischen Kontakte einer Chipkarte durch Lasergravur beschrieben. Dabei wird zur Markierung die Goldschicht lokal vollständig abgetragen, wobei die darunter liegende Nickelschicht, die auch teilweise mitabgetragen wird, sichtbar ist. Durch die damit verbundene Schädigung der Goldschicht wird der Korrosions- und Oxidationsschutz der metallischen Kontaktflächen verschlechtert.

Aufgabe der Erfindung ist es, ein Verfahren zu Herstellung einer Chipkarte mit metallischen Kontakten zu schaffen, wobei auf die Kontakte eine sichtbare Information aufgebracht werden soll ohne daß der Korrosions- und Oxidationsschutz der metallischen Kontakte beschädigt wird.

Diese Aufgabe wird durch die kennzeichnenden Merkmale der Patentansprüche 1 und 20 gelöst. Die sich daran anschließenden Unteransprüche enthalten vorteilhafte und förderliche Ausgestaltungen der Erfindung.

An Hand der beigefügten Zeichnungen soll die Erfindung nachfolgend näher erläutert werden. Es zeigt:
- Fig. 1: eine Draufsicht auf eine kontaktbehaftete Chipkarte,
- Fig.2: eine schematische Ansicht einer Laseranlage zur Durchführung des erfindungsgemäßen Verfahrens,
- Fig.3: einen Schnitt durch eine Chipkarte im Bereich der Kontakte,
- Fig.4: einen Schnitt durch den Schichtaufbau der Kontakte mit einer erfindungsgemäß durch Laserstrahlung verdampften Zone,
- Fig.5: einen Schnitt durch einen alternativen Schichtaufbau der Kontakte, wobei die verschiedenen Möglichkeiten des erfindungsgemäßen Verfahrens demonstriert sind,
- Fig.6 bis Fig.10: Draufsichten auf den vergrößert dargestellten Kontaktflächenbereich der Chipkarte mit erfindungsgemäß aufgebrachten, jeweils verschiedenen sichtbaren Elementen.

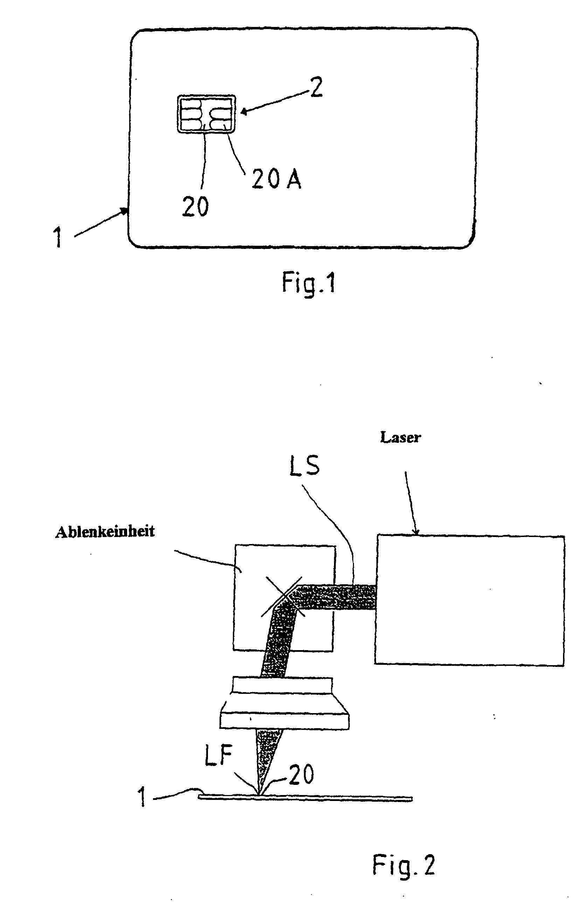

In Fig. 1 ist eine kontaktbehaftete Chipkarte (1) dargestellt. In der Chipkarte (1) befindet sich ein in einer zur Kartenvorderseite hin offenen Aussparung des Kartenkörpers fixiertes Chipmodul (2). Die Erfindung gibt ein Verfahren zur Ausgestaltung der metallischen Kontakte (20A), die die Oberfläche (20) des Chipmoduls (2) bilden an. Mit diesem Verfahren können sichtbare Informationen auf den Kontakten (20, 20A) erzeugt werden. Hierzu werden die Kontakte (20,20A), die aus wenigstens zwei übereinander angeordneten Metallschichten bestehen, mit Laserstrahlung (LS) beaufschlagt- siehe Fig.2. Dabei werden jeweils lokal (korrespondierend zu der darzustellenden Information) zwei oder mehrere Schichten unter dem Einfluß der Laserstrahlung (LS) jeweils lokal (korrespondierend zu der darzustellenden Information) zu einer Legierung verschmolzen. Die legierte Zone unterscheidet sich dabei in ihrer Farbe, d.h. in ihrem Reflexions- und Absorptionsspektrum, von dem umgebenden Bereich.

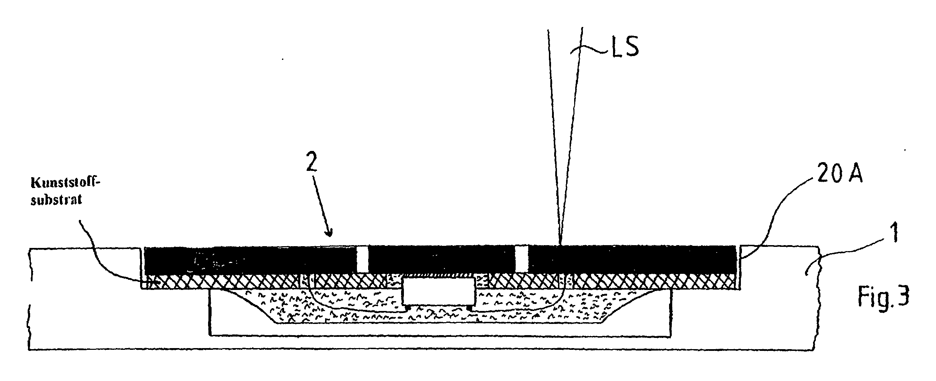

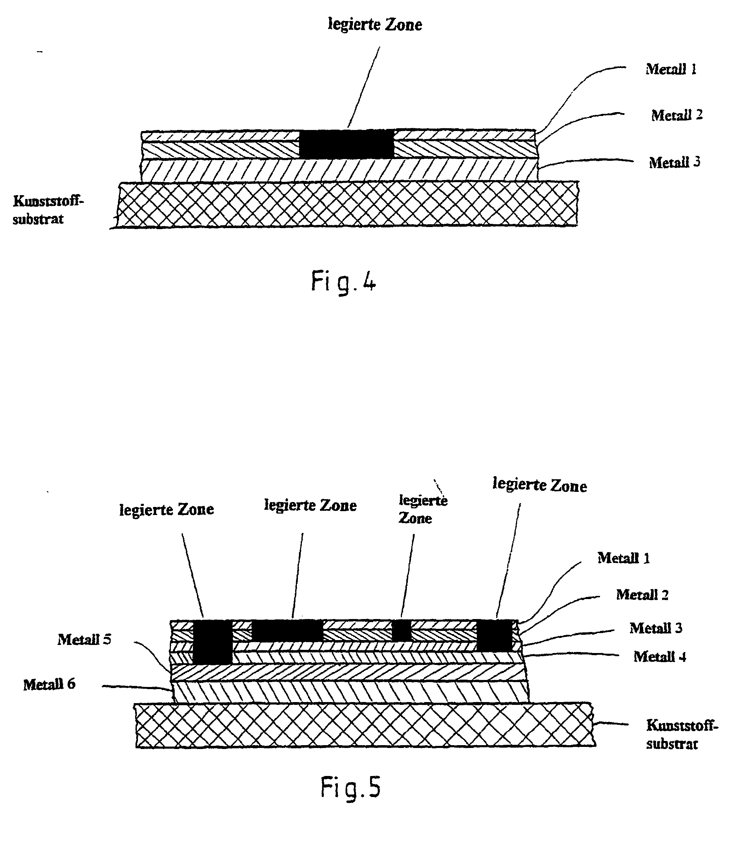

In Fig.3 ist zum besseren Verständnis ein Schnitt durch die Chipkarte (1) im Bereich des Chipmoduls (2) mit den Kontakten (20,20A) dargestellt. In Fig.4 und 5 sind unterschiedliche Schichtaufbauten der Kontakte (20,20A) dargestellt.

Typischerweise bestehen die Kontakte (20,20A) - vgl. Fig.4 - aus einer Kupferschicht (Metall 1), die auf ein Kunststoffsubstrat aufkaschiert wird, einer auf der Kupferschicht aufgebrachten Nickelschicht (Metall 2) und einer darauf aufgebrachten Gold-, Silber- oder Palladiumschicht (Metall 3). Die Schichtdicken sind nicht maßsstabsgerecht eingezeichnet. Die Kupferschicht hat typischer Weise eine Dicke von ca. 70µm, die Nickelschicht eine Dicke von ca. 1-5 µm und die darauf befindliche Edelmetallschicht eine Dicke von < 2µm.

Durch weitere Metallschichten - vgl. Fig.5 - und eine entsprechende Auswahl der Metalle hinsichtlich der Reflexions- und Absorptionseigenschaften der Reinmetalle als auch der Legierungen zwischen diesen Metallen ist eine breite Palette an verschieden farbigen Beschriftungsmöglichkeiten gegeben.
Beispielhaft sollen die folgenden Schichtaufbauten genannt werden:
Cu/Ni/Pd/Au
Cu/Ni/Pd
Cu/Edelmetall
Bronze/Edelmetall

Diese Schichten können auf ein Substrat galvanisch, durch Aufdampfen oder durch Sputtern aufgebracht werden.

In einer ersten Ausführungsform des Verfahrens erfolgt die Beaufschlagung der Kontakte (20,20A) mit der Laserstrahlung (LS) in der Weise, daß der Laserstrahl (LS) im Raster-oder Vektorverfahren über die Kontakte (20,20A) geführt wird. Ein dafür ausgelegte Laseranlage ist in Fig.2 gezeigt, welche eine elektronisch ansteuerbare Ablenkeinheit für den Laserstrahl (LS) aufweist. Derartige Anlagen werden bereits bei der sogenannten Kartenpersonalisierung eingesetzt, wo auf den Kunststoffkartenkörper z.B. eine Nummer gelasert wird. Der dafür verwendte Laser ist meistens ein Neodym-YAG-Laser. Damit ist das erfindungsgemäße Verfahren in einfacher Weise in den bestehenden Personalisierungsprozeß integriebar. Es lassen sich verschiedenste Informationen (Logos, alphanumerische Zeichen, Linien, Guillochen) auf den Kontakten (20,20A) sichtbar darstellen. Die Durchführung der erfindungsgemäßen Kontaktflächenbeschriftung mit einer solchen Anlage ist sehr flexibel, ohne apparative Umrüstungen einsetzbar:z.B. Aufbringen einer fortlaufenden Seriennummer, Aufbringen verschiedener Logos für verschiedene Chipkartenlose in der Fertigung.
Die Intensität des Laserstrahles (LS), die Geschwindigkeit mit der dieser über die Kontakte geführt wird sowie die Größe des Laserfleckes (LF) auf den Kontakten sind dabei in einfacher Weise einstellbar, um ein jeweils optimales Beschriftungsergebnis zu erzielen.

Um das in den isolierenden, metallfreien Zwischenräumen zwischen den Kontakten freiliegende Kunststoff-Substrat durch die Laserstrahlung nicht zu beschädigen, wird während der Führung des Laserstrahles (LS) über zwei oder mehrere Kontakte (20, 20A) hinweg dieser auf seinem Weg über den isolierenden Zwischenräumen ausgeschaltet, verschwenkt, abgeblendet oder abgeschwächt.

In einer zweiten Ausführungsform des Verfahrens ist es vorgesehen, die Beaufschlagung der Kontakte (20,20A) mit der Laserstrahlung im Maskentechnik-Verfahren (nicht dargestellt) durchzuführen. Dabei ist im Strahlengang der Laserstrahlung eine der aufzubringenden Information entsprechend ausgebildete Maske angeordnet. Dieses Verfahren ist besonders bei großen Stückzahlen vorteilhaft, wenn immer dieselbe Informtion (eine Maske, ein Maskensatz) aufgebracht wird. Die Maske ist dabei vorteilhafter Weise so ausgebildet, daß sie die Laserstrahlung an den isolierenden Zwischenräumen abschattet. Die Intensität und die Bestrahlungsdauer sind dabei auf die miteinander zu legierenden Metalle und die Zahl der aufzuschmelzenden Schichten abgestimmt.

Sowohl im Raster- und Vektorverfahren als auch im Maskenverfahren ist es einerseits vorgesehen, bereits mit Kontakten versehene Chipkarten zu beschriften. Darüber hinaus ist es außerdem vorgesehen, die Beschriftung der Kontakte (20,20A) schon auf einem Zwischenerzeugnis (nicht dargestellt) für die Herstellung von Chipmodulen (2) vorzunehmen. Dabei handelt es sich um sogenannte Substratbänder auf denen für die Herstellung einer Vielzahl von Chipmodulen die Kontakte (20,20A) aufgebracht sind.

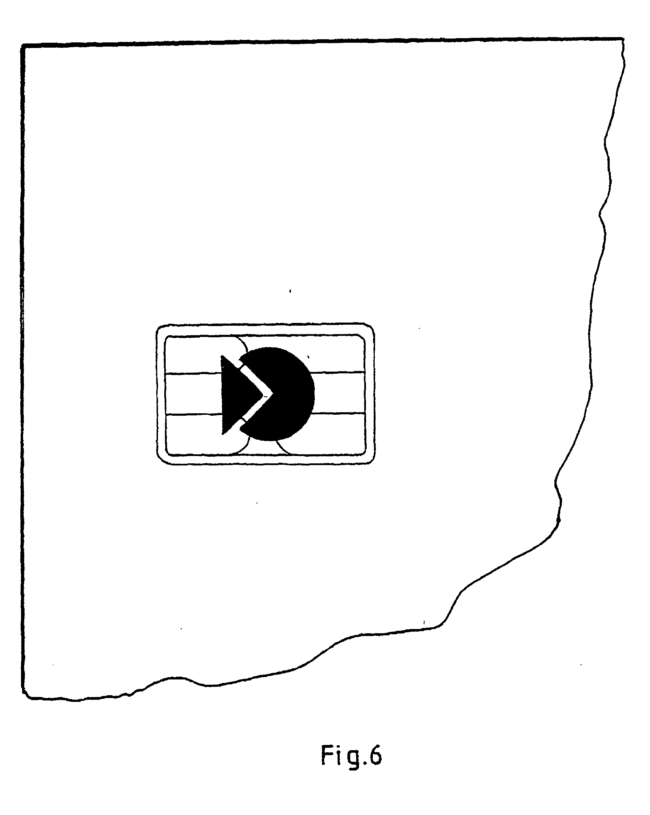

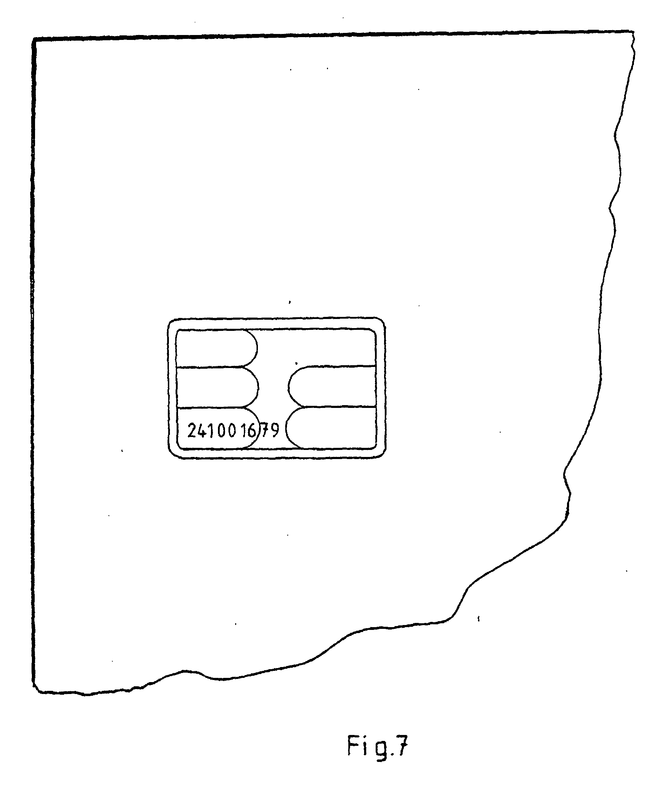

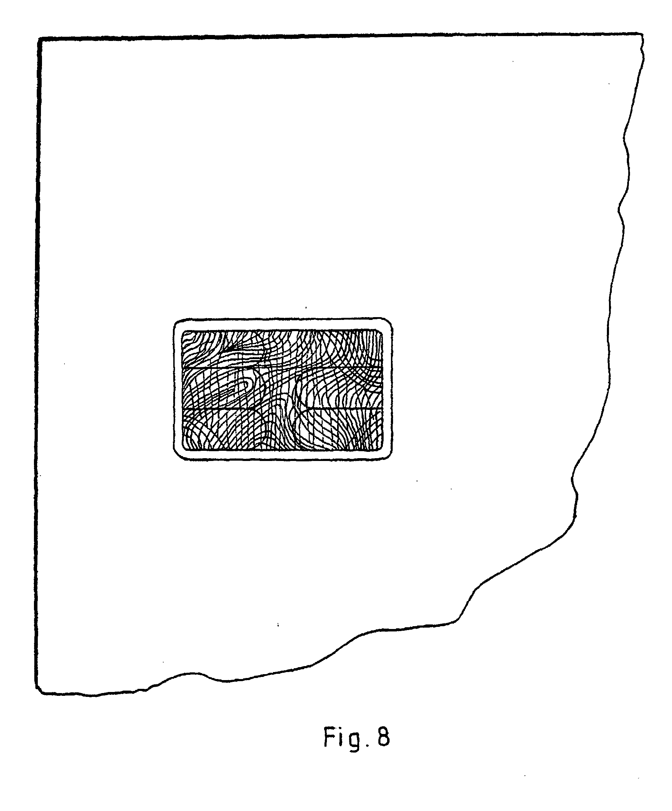

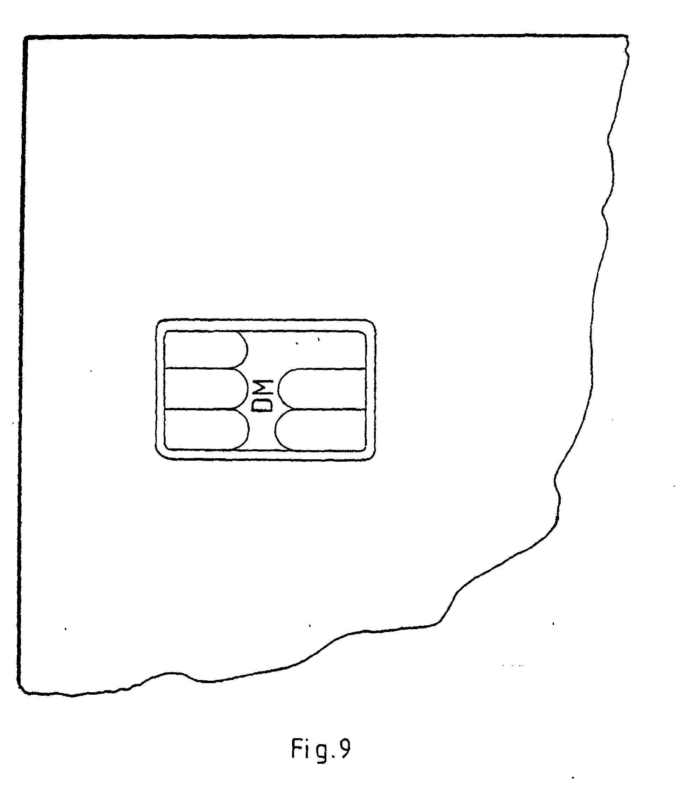

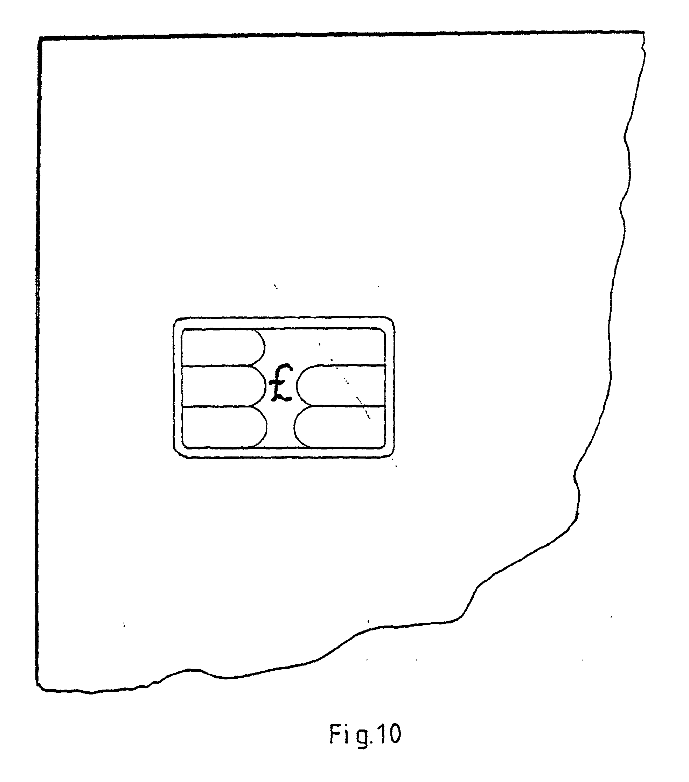

Auf den Fig.6 bis 10 sind zur Veranschaulichung einige der Möglichkeiten des erfindungsgemäßen Verfahrens dargestellt. In Fig. 6 ist gezeigt, wie mittels Laserstrahlung auf den Kontakten (20,20A) ein Logo aufgebracht wurde. Fig. 7 zeigt Kontakte (20,20A) mit aufgebrachter Seriennummer, Fig.8 zeigt ein aufgebrachtes Guillochenmuster, Fig.9 und 10 zeigen aufgebrachte Währungszeichen.
Hierbei wird deutlich, daß eine derartige Beschriftung auf den Kontakten (20,20A) auch als Sicherheitsmerkmal dient.

## Patentansprüche

1. Verfahren zur Herstellung von Chipkarten (1), die metallische Kontakte (20,20A) zur Kommunikation mit externen Geräten aufweisen, wobei die Kontakte (20,20A) von mindestens zwei übereinander angeordneten Schichten gebildet sind,
**dadurch gekennzeichnet, daß**
die Kontakte (20,20A) zur Ausbildung sichtbaren Informationen auf den Kontakten (20,20A) so mit einer Laserstrahlung beaufschlagt werden, daß zwei oder mehrere Schichten jeweils lokal unter dem Einfluß der Laserstrahlung zu einer Legierung verschmelzt werden.

2. Verfahren gemäß Anspruch 1, dadurch gekennzeichent, daß die Beaufschlagung der Kontakte mit der Laserstrahlung in der Weise erfolgt, daß ein Laserstrahl im Raster- oder Vektorverfahren über die Kontakte (20,20A) geführt wird.

3. Verfahren gemäß Anspruch 2, dadurch gekennzeichent, daß die Geschwindigkeit, mit der der Laserstrahl über die Kontakte (20,20A) geführt wird, so gewählt ist, daß die lokale Verweilzeit des Laserfleckes auf den Kontakten und der damit jeweils verbunde lokale Stahlungsernergieeintrag das lokale Verschmelzen der obersten Schicht und der darunter liegenden Schicht der Kontakte unter Ausbildung einer Legierung bewirkt.

4. Verfahren nach einem der vorstehenden Ansprüche, dadurch gekennzeichent, daß die Geschwindigkeit, mit der der Laserstrahl über die Kontakte (20,20A) geführt wird, so gewählt ist, daß die lokale Verweilzeit des Laserfleckes auf den Kontakten und der damit jeweils verbunde lokale Stahlungsernergieeintrag das lokale Verschmelzen von drei oder mehreren Schichten der Kontakte unter Ausbildung einer Legierung bewirkt.

5. Verfahren nach einem der vorstehenden Ansprüche, dadurch gekennzeichent, daß die Intensität des Laserstrahles während der Führung über die Kontakte (20,20A) jeweils lokal geändert wird.

6. Verfahren nach einem der vorstehenden Ansprüche, dadurch gekennzeichent, daß die Größe und/oder Form des Laserfleckes während der Führung über die Kontakte (20,20A) jeweils lokal geändert wird.

7. Verfahren nach einem der vorstehenden Ansprüche, **dadurch gekennzeichnet, daß** während der Führung des Laserstrahles über zwei oder mehrere Kontakte (20,20A) hinweg der Laserstrahl auf seinem Führungsweg über den isolierenden, metallfreien Zwischenräumen zwischen den Kontakten (20, 20A) ausgeschaltet, verschwenkt, abgeblendet oder abgeschwächt wird.

8. Verfahren gemäß Anspruch 1, dadurch gekennzeichent, daß die Beaufschlagung der Kontakte (20,20A) mit der Laserstrahlung in der Weise erfolgt, daß im Strahlengang der Laserstrahlung eine den aufzubringenden bildhaften Elementen und/oder alphanumerischen Zeichen entsprechend ausgebildete Maske angeordnet ist.

9. Verfahren nach Anspruch 8, **dadurch gekennzeichnet, daß** die Maske so ausgebildet ist, daß sie die Laserstrahlung an den isolierenden, metallfreien Zwischenräumen zwischen den Kontakten (20, 20A) abschattet.

10. Verfahren gemäß Anspruch 8 oder 9, dadurch gekennzeichent, daß die Intensität und Bestrahlungsdauer der Laserstrahlung so gewählt ist, daß das lokale Verschmelzen der obersten Schicht und der darunter liegenden Schicht der Kontakte unter Ausbildung einer Legierung bewirkt wird.

11. Verfahren gemäß Anspruch 8 oder 9, dadurch gekennzeichent, daß die Intensität und Bestrahlungsdauer der Laserstrahlung so gewählt ist, daß das lokale Verschmelzen von drei oder mehreren Schichten der Kontakte unter Ausbildung einer Legierung bewirkt wird.

12. Verfahren nach einem der vorstehenden Ansprüche, dadurch gekennzeichent, daß ein Neodym-YAG-Laser verwendet wird.

13. Verfahren nach einem der vorstehenden Ansprüche 1 bis 11, dadurch gekennzeichent, daß ein Excimer-Laser verwendet wird.

14. Verfahren nach einem der Ansprüche 1 bis 11, dadurch gekennzeichent, daß ein CO₂-Laser verwendet wird.

15. Verfahren nach einem der vorstehenden Ansprüche, dadurch gekennzeichent, daß die Beaufschlagung der Kontakte (20,20A) mit Laserstrahlung mittels eines im Pulsbetrieb arbeitenden Lasers erfolgt.

16. Verfahren nach einem der vorstehenden Ansprüche 1 bis 14, dadurch gekennzeichent, daß die Beaufschlagung der Kontakte (20,20A) mit Laserstrahlung mittels eines im kontinuierlich Modus arbeitenden Lasers erfolgt.

17. Verfahren nach einem der vorstehenden Ansprüche, **dadurch gekennzeichnet, daß** die Chipkarte (1) mit den darauf angeordneten Kontakten (20, 20 A) in einer Laserbeschriftungsanlage positioniert und anschließend die Kontakte zum Aufbringen der sichtbaren Information mit der Laserstrahlung beaufschlagt werden.

18. Verfahren nach einem der vorstehenden Ansprüche 1 bis 16, **dadurch gekennzeichnet, daß** die Beaufschlagung der Kontakte (20, 20A) mit der Laserstrahlung mit einem Zwischenerzeugnis, das für eine Vielzahl von Chipkarten die Kontakte aufweist, durchgeführt wird.

19. Verfahren nach einem der vorstehenden Ansprüche, **dadurch gekennzeichnet, daß** als Zwischenerzeugnis ein Chipmodulband verwandt wird, das eine Vielzahl von in Kartenkörper zu implantierende Chipmodule aufweist, wobei die Kontakte (20, 20A) jeweils die Oberfläche eines Chipmoduls (2) bilden, auf dessen Rückseite sich der Chip befindet.

20. Chipkarte hergestellt nach einem Verfahren gemäß einem der vorstehenden Ansprüche, **dadurch gekennzeichnet, daß** die Kontakte (20,20A) einen Schichtaufbau bestehend aus einer Kupfer-, Nickel- und mindestens einer Edelmetallschicht aufweisen und zwei oder mehrere Schichten jeweils lokal zur Ausbildung sicht barer Informationen auf den kontakten zu einer legierung verschmolzen sind.

21. Chipkarte nach Anspruch 20, **dadurch gekennzeichnet, daß** die Kontakte (20,20A) eine Goldschicht aufweisen.

22. Chipkarte nach Anspruch 20, **dadurch gekennzeichnet, daß** die Kontakte (20,20A) eine Silberschicht aufweisen.

23. Chipkarte nach Anspruch 20, **dadurch gekennzeichnet, daß** die Kontakte (20,20A) eine Palladiumschicht aufweisen.

24. Chipkarte nach Anspruch 20, **dadurch gekennzeichnet, daß** die Kontakte (20,20A) eine Palladium- und eine Goldschicht aufweisen.

25. Chipkarte nach Anspruch 20, **dadurch gekennzeichnet, daß** die Kontakte (20,20A) einen Schichtaufbau bestehend aus einer Kupfer- und einer Edelmetallschicht aufweisen.

26. Chipkarte nach Anspruch 20, **dadurch gekennzeichnet, daß** die Kontakte (20,20A) einen Schichtaufbau bestehend aus einer Bronze- und einer Edelmetallschicht aufweisen.

## Claims

1. Method for manufacturing smart cards (1) having metallic contacts (20, 20A) for communicating with external devices, in which the contacts (20, 20A) are formed by at least two layers arranged above one another,
**characterized in that**
for forming visual information on the contacts (20, 20A), laser radiation is applied to the contacts (20, 20A) so that two or more layers are in each case fused locally to form an alloy under the influence of the laser radiation.

2. Method according to Claim 1, **characterized in that** the laser radiation is applied to the contacts in such a way that a laser beam is guided over the contacts (20, 20A) using a raster or vector method.

3. Method according to Claim 2, **characterized in that** the speed at which the laser beam is guided over the contacts (20, 20A) is selected so that the local dwell time of the laser spot on the contacts and the respective local radiative energy input associated therewith causes the local fusing of the top layer and the underlying layer of the contacts so as to form an alloy.

4. Method according to one of the preceding claims, **characterized in that** the speed at which the laser beam is guided over the contacts (20, 20A) is selected so that the local dwell time of the laser spot on the contacts and the respective local radiative energy input associated therewith causes the local fusing of three or more layers of the contacts so as to form an alloy.

5. Method according to one of the preceding claims, **characterized in that** the intensity of the laser beam is changed locally in each case while it is being guided over the contacts (20, 20A).

6. Method according to one of the preceding claims, **characterized in that** the size and/or shape of the laser spot is changed locally in each case while it is being guided over the contacts (20, 20A).

7. Method according to one of the preceding claims, **characterized in that** during guidance of the laser beam over two or more contacts (20, 20A) and beyond, the laser beam is switched off, swiveled, dimmed or attenuated on its guide path over the insulating, metal-free interspaces between the contacts (20, 20A).

8. Method according to Claim 1, **characterized in that** the laser radiation is applied to the contacts (20, 20A) in such a way that a mask designed in accordance with the pictorial elements and/or alphanumeric characters to be produced is arranged in the beam path of the laser radiation.

9. Method according to Claim 8, **characterized in that** the mask is designed in such a way that it shades the laser radiation at the insulating, metal-free interspaces between the contacts (20, 20A).

10. Method according to Claim 8 or 9, **characterized in that** the intensity and irradiation period of the laser radiation is selected so that the local fusing of the top layer and the underlying layer of the contacts is effected so as to form an alloy.

11. Method according to Claim 8 or 9, **characterized in that** the intensity and irradiation period of the laser radiation is selected so that the local fusing of three or more layers of the contacts is effected so as to form an alloy.

12. Method according to one of the preceding claims, **characterized in that** a neodymium YAG laser is used.

13. Method according to one of the preceding Claims 1 to 11, **characterized in that** an excimer laser is used.

14. Method according to one of the preceding Claims 1 to 11, **characterized in that** a CO₂ laser is used.

15. Method according to one of the preceding claims, **characterized in that** laser radiation is applied to the contacts (20, 20A) using a pulsed operation laser.

16. Method according to one of the preceding Claims 1 to 14, **characterized in that** laser radiation is applied to the contacts (20, 20A) using a continuous mode laser.

17. Method according to one of the preceding claims, **characterized in that** the smart card (1) with the contacts (20, 20A) arranged thereon is positioned in a laser inscription system then laser radiation is applied to the contacts to produce the visual information.

18. Method according to one of the preceding Claims 1 to 16, **characterized in that** the application of laser radiation to the contacts (20, 20A) is carried out using an intermediate product having the contacts for a plurality of smart cards.

19. Method according to one of the preceding claims, **characterized in that** a chip module strip having a plurality of chip modules to be implanted in card bodies is used as the intermediate product, wherein the contacts (20, 20A) form in each case the surface of a chip module (2), on the rear of which the chip is located.

20. Smart card manufactured using a method according to one of the preceding claims, **characterized in that** the contacts (20, 20A) have a laminar structure comprising a copper, nickel and at least one noble-metal layer, and for forming visual information on the contacts (20, 20A) two or more layers are in each case fused locally to form an alloy.

21. Smart card according to Claim 20, **characterized in that** the contacts (20, 20A) have a gold layer.

22. Smart card according to Claim 20, **characterized in that** the contacts (20, 20A) have a silver layer.

23. Smart card according to Claim 20, **characterized in that** the contacts (20, 20A) have a palladium layer.

24. Smart card according to Claim 20, **characterized in that** the contacts (20, 20A) have a palladium layer and a gold layer.

25. Smart card according to Claim 20, **characterized in that** the contacts (20, 20A) have a laminar structure comprising a copper layer and a noble-metal layer.

26. Smart card according to Claim 20, **characterized in that** the contacts (20, 20A) have a laminar structure comprising a bronze layer and a noble-metal layer.

## Revendications

1. Procédé pour la fabrication de cartes à puce (1) présentant des contacts métalliques (20, 20A) pour établir la communication avec des appareils externes, lesdits contacts (20, 20A) étant composés d'au moins, deux couches superposées, **caractérisé en ce que** les contacts (20, 20A) pour la formation d'informations visibles sur les contacts (20, 20A) sont soumis à un faisceau laser de sorte que deux ou plusieurs couches fondent chacune localement sous l'influence du faisceau laser en formant un alliage.

2. Procédé selon la revendication 1, **caractérisé en ce que** le traitement des contacts au faisceau laser est effectuée de sorte qu'un faisceau laser est guidé sur les contacts (20, 20A) selon le procédé tramé ou vectoriel.

3. Procédé selon la revendication 2, **caractérisé en ce que** la vitesse, à laquelle le faisceau laser est conduit sur les contacts (20, 20A), est sélectionnée de sorte que le temps de séjour local du spot laser sur les contacts et l'apport d'énergie local du faisceau laser y associé provoquent la fusion locale de la couche supérieure des contacts et de la couche située sous celle-ci, en formant un alliage.

4. Procédé selon la revendication 2, **caractérisé en ce que** la vitesse, à laquelle le faisceau laser est conduit sur les contacts (20, 20A), est sélectionnée de sorte que le temps de séjour local du spot laser sur les contacts et l'apport d'énergie du faisceau laser y associé respectivement, provoquent la fusion locale de trois ou de plusieurs couches des contacts en formant un alliage

5. Procédé selon l'une des revendications précédentes, **caractérisé en ce que** l'intensité du faisceau laser, au cours du balayage des contacts (20, 20A) est modifiée chaque fois localement.

6. Procédé selon l'une des revendications précédentes, **caractérisé en ce que** la grandeur et / ou la forme du spot laser est modifiée chaque fois localement, pendant le balayage des contacts (20, 20A).

7. Procédé selon l'une des revendications précédentes, **caractérisé en ce que**, pendant le guidage du faisceau laser sur deux ou plusieurs contacts (20, 20A), le faisceau laser est coupé, pivoté, mis en veilleuse ou atténué au cours de son passage sur les intervalles isolants, exempts de métal, situés entre les contacts (20, 20A).

8. Procédé selon la revendication 1, **caractérisé en ce que** la traitement des contacts (20, 20A) avec le faisceau laser est effectué de sorte qu'un masque, conçu conformément aux éléments d'images et / ou aux signes alphanumériques, est disposé dans le parcours du faisceau laser.

9. Procédé selon la revendication 8, **caractérisé en ce que** le masque est conçu de sorte qu'il obscurcit le rayonnement du faisceau laser dans les intervalles isolants, exempt de métal, situés entre les contacts (20, 20A).

10. Procédé selon la revendication 8 u 9, **caractérisé en ce que** l'intensité et la durée de rayonnement du laser sont sélectionnées de sorte que la fusion locale de la couche supérieure et de la couche suivante des contacts a lieu en formant un alliage.

11. Procédé selon la revendication 8 u 9, **caractérisé en ce que** l'intensité et la durée de rayonnement du laser sont sélectionnées de sorte que la fusion locale de trois ou de plusieurs couches des contacts a lieu en formant un alliage.

12. Procédé selon l'une des revendications précédentes, **caractérisé en ce qu'**un laser à néodyme GYA est utilisé.

13. Procédé selon l'une des revendications précédentes, **caractérisé en ce qu'**un laser à excimères est utilisé.

14. Procédé selon l'une des revendications précédentes, **caractérisé en ce qu'**un laser CO_{χ} est utilisé.

15. Procédé selon l'une des revendications précédentes, **caractérisé en ce que** le traitement des contacts (20, 20A) au faisceau laser est effectué à l'aide d'un laser en fonctionnement impulsionnel.

16. Procédé selon l'une des revendications 1 à 14, **caractérisé en ce que** le traitement des contacts (20, 20A) au faisceau laser est effectué à l'aide d'un laser fonctionnant en mode continu.

17. Procédé selon l'une des revendications précédentes, **caractérisé en ce que** la carte à puce (1) avec les contacts (20, 20A) disposés sur elle, est positionnée dans une installation de l'inscription au laser et que les contacts sont ensuite soumis au rayonnement du laser pour la formation de l'information visible.

18. Procédé selon l'une des revendications 1 à 14, **caractérisé en ce que** le traitement des contacts (20, 20A) au faisceau laser est effectué à l'aide d'un laser en fonctionnement impulsionnel.

19. Procédé selon l'une odes revendications précédentes, **caractérisé en ce qu'**un ruban de modules à puce est utilisé comme produit intermédiaire, lequel présente un grand nombre de modules à puce à implanter dans le corps de la carte, les contacts (20, 20A) formant chacun la surface d'un module à puce (2), au verso duquel la puce est installée.

20. Carte à puce, fabriquée selon un procédé selon l'une des revendications précédentes, **caractérisée en ce que** les contacts (20, 20A) présentent une structure en couches composée d'une couche de cuivre, d'une couche de nickel et d'au moins une couche de métal précieux et que deux ou plusieurs couches sont fondues chacune, localement, en un alliage, pour la formation d'informations visibles sur les contacts.

21. Carte à puce selon la revendication 20, **caractérisée en ce que** les contacts (20, 20A) présentent une couche d'or.

22. Carte à puce selon la revendication 20, **caractérisée en ce que** les contacts (20, 20A) présentent une couche d'argent.

23. Carte à puce selon la revendication 20, **caractérisée en ce que** les contacts (20, 20A) présentent une couche de palladium.

24. Carte à puce selon la revendication 20, **caractérisée en ce que** les contacts (20, 20A) présentent une couche de palladium et une couche d'or.

25. Carte à puce selon la revendication 20, **caractérisée en ce que** les contacts (20, 20A) présentent une structure en couches composée d'une couche de cuivre et d'une couche de métal précieux.

26. Carte à puce selon la revendication 20, **caractérisée en ce que** les contacts (20, 20A) présentent une structure en couche composée d'une couche de bronze et d'une couche de métal précieux.
